# EUROPEAN PATENT SPECIFICATION

(11) **EP 1 779 418 B1**
(45) Date of publication and mention of the grant of the patent: **17.09.2014**
(21) Application number: 05773487.3
(22) Date of filing: 17.06.2005
(51) Int. Cl.: G01J 1/02, G01J 1/42, G01J 3/02, G01J 5/02, G01J 5/20

(54) **PHOTONIC CRYSTAL EMITTER, DETECTOR, AND SENSOR**
EMITTER, DETEKTOR UND SENSOR MIT PHOTONISCHEM KRISTALL
EMETTEUR, DETECTEUR ET CAPTEUR A CRISTAUX PHOTONIQUES

(30) Priority: 17.06.2004 US 580574 P; 08.07.2004 US 586334 P
(43) Date of publication of application: 02.05.2007
(73) Proprietor: Ion Optics, Inc., Waltham, MA 02154 (US)
(72) Inventor: PRALLE, Martin, U., Wayland, MA 01778 (US); DALY, James, T., Mansfield, MA 02048 (US); PUSCASU, Irina, Somerville, MA 02145 (US); MCNEAL, Mark, P., Marlborough, MA 01752 (US); JOHNSON, Edward, A., Bedford, MA 01730 (US)
(74) Representative: Rickard, David John
(86) International application number: PCT/US2005/021617
(87) International publication number: WO 2006/007446

(56) References cited:
- WO-A1-98/57402
- US-A- 4 874 953
- US-A- 5 955 749
- US-A- 5 973 316
- US-A1- 2001 019 565
- PRALLE M U ET AL: "Photonic crystal enhanced narrow-band infrared emitters" APPLIED PHYSICS LETTERS, AIP, AMERICAN INSTITUTE OF PHYSICS, MELVILLE, NY, US LNKD- DOI:10.1063/1.1526919, vol. 81, no. 25, 16 December 2002 (2002-12-16), pages 4685-4687, XP012032784 ISSN: 0003-6951
- EL-KADY I ET AL: "Tunable narrow-band infrared emitters from hexagonal lattices" PHOTONICS AND NANOSTRUCTURES, ELSEVIER, AMSTERDAM, NL LNKD- DOI:10.1016/J.PHOTONICS.2003.10.002, vol. 1, 1 January 2003 (2003-01-01), pages 69-77, XP002998515 ISSN: 1569-4410
- PRALLE M U ET AL: "PHOTONIC CRYSTALS FOR NARROW-BAND INFRARED EMISSION" PROCEEDINGS OF THE INTERNATIONAL SOCIETY FOR OPTICAL ENGINEERING (SPIE), SPIE, USA LNKD- DOI:10.1117/12.455159, vol. 4574, 1 January 2002 (2002-01-01), pages 193-200, XP001197243 ISSN: 0277-786X

## Description

### FIELD OF THE INVENTION

The present invention relates to infrared emitters/detectors/sensors for emitting and/or detecting infrared electromagnetic energy, and more particularly, to micromachined devices for emitting and/or detecting infrared electromagnetic waves.

### BACKGROUND OF THE INVENTION

Infrared emitters/detectors/sensors are used in many applications, for example, in detecting and discriminating the presence of specific biological, chemical substances (e.g., gases).

A conventional detector or sensor typically includes a heated element as a source of infrared emission, a filter for controlling the wavelength of emitted light, and a detector for detecting the absorption of the emitted light by a substance interacting with the emitted light. The source, referred to henceforth as an IR (infrared) emitter, typically includes a wire, filament or other infrared radiating elements. To activate, the IR emitter is heated by passing electric current through the conductive wire or filament. The current is converted to heat in the wire or filament. The infrared emission from the wire or filament is proportional to the temperature and surface area of the heated element. Often, it may be desirable to pulse the infrared emission by interrupting the electrical current periodically to modulate the surface temperature of the heated element. A spectral filter is used to selectively tailor the spectrum of the infrared emission to substantially match the absorption characteristics of the target substance to be detected.

The detector is placed facing the emitter and filter for receiving the light passed through the filter. In one example of a detector, the electrical resistance R varies as a function of its temperature T, i.e., R=f{T}. The function f{T} may be determined empirically or analytically for a particular detector. The temperature T of the detector is dependent upon how fast it cools, and the cooling rate of the detector is dependent on the optical absorption characteristics of its immediate environment. In general, different substances (e.g., gases) are known to each exhibit distinct optical absorption characteristics. The spectral filter may be selected such that the infrared source and sensor forms a tuned cavity band emitter corresponding to the absorption characteristics of the gas under study. Thus, when the targeted gas is present in the optical path between the emitter and the detector, the optical energy received by the detector is reduced, and the temperature of the detector drops, which in turn results in changing of the resistance of the detector. Thereby, the gas is detected by monitoring the resistance R of the detector.

The thermal emissions of the current emitters used in the sensors have always been associated with a black body spectrum. Although a spectral filter is used to achieve a specific spectrum of interest, the cost of the sensing device may be high and the accuracy of the device may be reduced. Furthermore, the sensors constructed as described above are multi-component systems requiring special alignment, calibration, and separate electronics for both the emitter and the detector making this sensors complex and expensive.

Another technique currently used is utilizing a diode laser as emission source. While this technique is highly sensitive and less subject to contamination and false alarms than electrochemical sensors, the units are expensive for home installation. In addition, because they depend on physical band-gaps, diode lasers can only be tuned with difficulty within a very narrow range.

Recently, photonic bandgap structures, such as periodic dielectric arrays, have received much attention as optical and infrared filters with controllable narrow-band infrared absorbance. These photonic structures have been developed as transmission/reflection filters.

One type of device embodying a structure similar to a photonic bandgap structure is disclosed in U.S. Patent No. 5,973,316. The device includes a metallic film having apertures located therein in an array arranged in a pattern so that when light is incident on the apertures, surface plasmons on the metallic film are perturbed resulting in an enhanced transmission of the light emitted from individual apertures in the array. The light transmission properties of such an apparatus are strongly dependent upon the wavelength of the light. Enhanced transmission occurs for light wavelengths in relation to the inter-aperture spacing. The aperture array is used to filter light of predetermined wavelengths traversing the apertures. The device disclosed in U.S. Patent No. 5,973,316 is primarily used in filters, and, generally, an external light source (emitter) is still needed to generate light that impinges onto the aperture array.

U.S. Patent No. 6,756,594 (or U.S. Patent Publication No. 2002/0096492, which is issued as U.S. Patent No. 6,756,594) discloses a sensor engine, which is a micro-machined infrared absorption emitter/sensor, for detecting the presence of specific chemical and/or biological species. The sensor engine includes a substrate surface having emission features disposed thereon. The substrate is made of a metallized single- crystal silicon. However, the devices disclosed in the U.S. Patent No. 6,756,594 are not suitable for very-high-temperature applications.

WO98/57402 discloses a resonant reflector provided in combination with a Distributed Bragg Reflector mirror for a vertical cavity surface-emitting laser or resonant cavity photodetector.

Pralle M U et al: "Photonic Crystal Enhanced Narrow Band Infrared Emitters", Applied Physics Letters, AIP, American Institute of Physics, Melville, NY, vol. 81, no. 25, 16 December 2002, pages 4685 to 4687 discloses devices for emitting and/or absorbing electromagnetic energy having a silicon based semiconductor material layer having a photonic bandgap surface structure, which are not suitable for very-high-temperature applications.

Accordingly, a need exists for an inexpensive emitter system capable of accurately emitting infrared light in a specific spectrum. It is desired that the device exhibits high stability at very high temperatures.

### SUMMARY

The present invention is generally directed to an infrared emitter/detector/sensor for emitting and/or detecting infrared electromagnetic energy. According to one aspect of the present invention, the device constructed according to the invention is utilized in devices and systems for sensing the presence of substances of interest.

A main aspect of the invention provides a device for emitting and/or absorbing electromagnetic energy as disclosed in claim 1.

The infrared emitter utilizes a photonic bandgap (PBG) structure to produce electromagnetic emissions with a narrow band of wavelengths. A PBG structure is an artificially engineered periodic dielectric array in which the propagation of electromagnetic waves is governed by band structure-like dispersion. The structure exhibits allowed and forbidden propagation of electronic energy bands. The absence of allowed propagating electromagnetic wave modes inside the structures, in a range of wavelengths called a photonic band gap, gives rise to distinct optical phenomena such as inhibition of spontaneous emission, high-reflecting omnidirectional mirrors, low-loss-waveguides, etc.

According to one preferred embodiment, the emitter includes a semiconductor material layer, a dielectric material layer overlaying the semiconductor material layer, and an electrically conductive material layer having an inner side overlaying the dielectric material layer. Preferably, the semiconductor material layer is made from single-crystal silicon carbide (SiC), polycrystalline silicon carbide (poly-SiC), germanium, or the group III-V semiconductors, the group II-VI semiconductors including alloys of indium, gallium, aluminum, arsenic, antimony, and phosphorous, and alloys of zinc, mercury, cadmium, tellurium, sulphur and selenium. SiC exhibits a high stability at high temperatures, which makes SiC a good candidate for the emitter devices according to the present invention, especially for the devices that operate in a high temperature environment. The semiconductor material layer may be doped with N type or P type impurities. The dielectric material layer is preferably made from silicon dioxide, although other dielectric materials may be used. According to one aspect of the present invention, the dielectric material layer is selected from the group consisting of silicon nitride, alumina, sapphire, aluminum nitride, and silicon oxinitride. The electrically conductive material layer can be made from a metallic material or metallic-like material. The metallic material is preferably selected from but not limited to a group consisting of gold, aluminum, nickel, silver, titanium, and platinum, or an alloy of the above metals. The metallic-like material refers to a heavily doped semiconductor or a conductive ceramic selected from the group consisting of titanium nitride, tantalum nitride and indium tin oxide or other non-metal electrically conductive materials. The titanium nitride material allows conventional CMOS fabrication techniques to be used in the fabrication of the device according to the present invention. The electrically conductive material layer hereinafter is referred to as a metal or metallic-like material layer. Thus, the metallic-like layer can be a highly doped semiconductor with effective metallic properties or a conductive ceramic preferably made from but not limited to a group consisting of titanium nitride, tantalum nitride, and indium tin oxide. The semiconductor material layer is capable of being coupled to an energy source for introducing energy to the semiconductor material layer. The metallic material layer includes periodically distributed surface features on an outer side thereof opposite the inner side. The three material layers are adapted to transfer energy from the semiconductor material layer to the outer side of the metallic material layer and emit electromagnetic energy in a narrow band of wavelengths from the outer side of the metallic material layer. The device may have more than three or less than three layers of materials. The multi-layer structure emits electromagnetic waves with narrow peak wavelengths based on their resonances.

According to the invention, the emitted electromagnetic energy has wavelengths centered about a characteristic wavelength (λ) and having a full width at half maximum (Δλ), where Δλ/λ is equal to or less than 0.5

In one preferred form, the periodically distributed surface features are empty spaces or void regions, preferably holes, defined in the metallic material layer. The periodically distributed surface features preferably employ a distribution geometry, for example, a rectangular, hexagonal, or parallelogram distribution geometry. In a preferred form, the holes are defined with a substantially circular shape extending about a central axis transverse to the layers of the materials. The holes may employ other shapes, for example, an oval shape, a cross-shape, , an X-shape, a square shape with round-shaped corners, or a triangular, hexagonal, rectangular, or other suitable shapes, including but not limited to polygonal shapes.

The diameter of the substantially circular holes and the inter-spacing between two holes can be varied in different embodiments. In one exemplary embodiment, the metal layer is about 0.1 µm thick, and the diameter of the holes is about 2 µm and the center to center spacing between two holes is about 4.2 µm. In other embodiments, in which the empty spaces are configured with rectangular or other shapes, the size and the spacing between two empty spaces can also be different.

The holes or the empty spaces can be defined with different depths (with respect to the principal plane of the layers) in different embodiments. For example, the holes may extend partially into or through the metal layer. In another form, the holes extend through the metal layer and at least partially into the dielectric layer. In another form, the holes may extend through the metal layer and the dielectric layer, and at least partially into or fully through the semiconductor layer.

It should be understood that various shape, size, depth, or spacing of the periodically distributed empty spaces can be used in the present invention. The emission or absorption peak wavelength and the width of the narrowband wavelengths around the peak wavelength associated with the device can be adjusted by selecting the geometrical shape, size, depth, and spacing of the periodically distributed empty spaces. The peak wavelength and the width of the narrowband wavelengths also can be adjusted by selecting different materials, for example, different metals as the metal layer, or by adjusting the dopant concentration in the semiconductor layer.

According to the present invention, the emitter device includes a semiconductor layer having a metal layer deposited on the semiconductor layer. The semiconductor layer is capable of being coupled to an energy source. The device is patterned with periodically distributed surface features, preferably holes, each extending about a central axis transverse the semiconductor layer and the metal layer of the device. The configurations of the periodically distributed holes including the size, shape, depth, spacing, and distribution geometry can be the varied in different embodiments as described above.

According to a further preferred embodiment of the present invention, the device may only include one semiconductor layer, which includes periodically distributed surface features, preferred an array of holes defined on an upper surface of the semiconductor layer.

According to a further aspect of the present invention, the emitter device is preferably constructed as a membrane having an aspect ratio of the length or width to the thickness greater than 10. In this form, the membrane is preferably suspended from a frame by suspension arms. The device can be manufactured by MEMS techniques. The frame and the suspension arms can be made from silicon, silicon carbide, or other materials. Preferably the membrane, suspension arms, and the frame are made from one semiconductor wafer and are constructed as an integral structure. The suspension arms may be electrically conductive permitting conduction of electrical current to the semiconductor layer of the device to heat the semiconductor layer. Preferably the membrane is thermally isolated from the frame to increase the accuracy of the device. The resulting MEMS device can be configured with other structures. For example, the membrane may be supported by supporting legs on a substrate. Contacts may be formed on the supporting legs for conducting electrical energy to the semiconductor layer of the emitter device.

According to another preferred embodiment, the device may be covered by a transparent covering which is preferably coated with a thin film to decrease reflection of the transparent covering. In one preferred form, the transparent covering is made from silicon. The covering is bonded to the substrate and the emitter/detector device is sealed in the interior region formed by the substrate and the covering from the outside environment.

The fabrication of the emitter device may utilize MEMS manufacturing methods available in the art, which generally includes a number of photolithography and etching steps. Fabrication of the structure of the device, which uses a relative thick silicon layer as the semiconductor layer, may include growing oxide on a silicon substrate to form the silicon dioxide layer, depositing a metal layer on the silicon dioxide layer, and etching the structure to form the holes on the device. In the embodiments in which silicon carbide is used as the semiconductor layer, a Multi-User Silicon Carbide (MUSiC) process can be used to fabricate the surface of the silicon carbide.

The MEMS device employing a membrane may be fabricated on an SOI silicon wafer, which includes a device layer, a dielectric layer, and a handle layer. The PGB etch is performed to pattern the membrane. Then the membrane is defined in the device layer using deep reactive ion etching (DRIE). The device is released by a backside-through etch, resulting in a suspended membrane structure spanning an open cavity. A sacrificial material may be deposited to support the membrane. The sacrificial material is then removed from the device.

The emitter devices are preferably fabricated in large numbers on a wafer of a semiconductor material. In wafer level manufacturing and packaging, an array of the emitter devices (which can be any embodiment as described above) are first fabricated on a wafer. Another wafer is etched to form an array of transparent coverings. The two wafers are then aligned and are bonded together. It is preferred that the two wafers are bonded together by silicon direct bonding. Silicon direct bonding, which is also called silicon fusion bonding, is a wafer-to-wafer bonding technology known in the art. The sealed devices formed by the two bonded wafers are then separated into individual devices by selectively etching the two bonded wafers. Alternatively, an array of the emitter devices are fabricated on a device wafer, which is then attached to a packaging wafer. A covering wafer is then bonded to the device wafer and the packaging wafer to seal the emitter devices. The devices are then separated into discrete devices.

According to a further aspect of the present invention, an emitter device assembly may include an array of the emitter devices. In a preferred form, the array of the emitter devices are addressable individually or in groups. For example, each device may include electrical conductors extending through the substrate and are connected to an external power source and/or a controller, such that the each device can be individually powered and/or controlled. The emitter assembly may be used in sensing or imaging systems.

### BRIEF DESCRIPTION OF THE DRAWINGS

These and other features and advantages of the present invention will be better understood by reference to the following detailed description when considered in conjunction with the accompanying drawings wherein:
FIG. 1 is a schematic side view of a preferred embodiment of the emitter/detector according to the present invention;
FIG. 2 is a schematic cross-sectional view of a preferred embodiment of the emitter/detector according to the present invention;
FIG. 3A is a schematic top view of a preferred embodiment of the emitter/detector according to the present invention, showing a square distribution geometry of periodically distributed surface features;
FIG. 3B is a shematic top view of another preferred embodiment of the emitter/detector according to the present invention, showing a parallelogram distribution geometry of periodically distributed surface features;
FIG. 4A is a schematic top view of a metal layer of another preferred embodiment of the emitter/detector according to the present invention;
FIG. 4B is a schematic top view of a metal layer of a further preferred embodiment of the emitter/detector according to the present invention;
FIG. 5A is a schematic top view of one preferred embodiment of the emitter/detector according to the present invention, showing a cross shape of the holes etched into the device;
FIG. 5B is a schematic top view of one preferred embodiment of the emitter/detector according to the present invention, showing a square shape of the holes etched into the device;
FIG. 5C is a schematic top view of one preferred embodiment of the emitter/detector according to the present invention, showing a donut shape of the holes etched into the device;
FIG. 5D is a schematic top view of one preferred embodiment of the emitter/detector according to the present invention, showing a C-reverse-C shape of the holes etched into the device;
FIG. 6A is a schematic cross-sectional view of a preferred embodiment of the emitter/detector according to the present invention;
FIG. 6B is a schematic cross-sectional view of another preferred embodiment of the emitter/detector according to the present invention;
FIG. 6C is a schematic cross-sectional view of a further preferred embodiment of the emitter/detector according to the present invention;
FIG. 6D is a schematic cross-sectional view of another preferred embodiment of the emitter/detector according to the present invention;
FIG. 6E is a schematic cross-sectional view of a further preferred embodiment of the emitter/detector according to the present invention;
FIG. 7 is a schematic cross-sectional view of a preferred embodiment of the emitter/detector according to the present invention;
FIG. 8 is a schematic cross-sectional view of another preferred embodiment of the emitter/detector according to the present invention;
FIG. 9 is a schematic cross-sectional view of a further preferred embodiment of the emitter/detector according to the present invention;
FIG.10A is a schematic top view of one preferred embodiment of the emitter/detector according to the present invention, showing a membrane suspended in a frame;
FIG. 10B is a schematic top view of another preferred embodiment of the emitter/detector according to the present invention, showing a membrane suspended in a frame;
FIG.10C is a schematic top view of a further preferred embodiment of the emitter/detector according to the present invention, showing a membrane suspended in a frame;
FIG.10D is a schematic top view of one preferred embodiment of the emitter/detector according to the present invention, showing a membrane suspended in a frame;
FIG. 11A is a schematic side view of one preferred embodiment of the emitter/detector according to the present invention, showing a membrane suspended on a substrate;
FIG. 11B is a schematic side view of another preferred embodiment of the emitter/detector according to the present invention, showing a membrane supported on a substrate;
FIG. 12A is a schematic cross-sectional view of one preferred embodiment of the emitter/detector according to the present invention, showing a device packaged in an enclosure;
FIG. 12B is a schematic cross-sectional view of one preferred embodiment of the emitter/detector according to the present invention, showing a device packaged in an enclosure;
FIG. 13 is a schematic cross-sectional view of one preferred embodiment of the emitter/detector according to the present invention, showing a device employing an array of emitters/detectors;
FIG.14 illustrates an example of a sensing system embodying the emitter/detector of the present invention;
FIG. 15 illustrates an analytical diagram of the device shown in FIG.14, showing an emission spectrum of the prototype device in FIG. 14 compared with an emission spectrum of a blackbody;
FIG.16A is a top view of one preferred embodiment of the emitter/detector according to the present invention;
FIG.16B is a cross-sectional view of the preferred embodiment of the emitter/detector shown in FIG.16A; and
FIG.17 is a diagram showing a plot of peak wavelengths as a function of lattice spacing.

### DETAILED DESCRIPTION OF THE PREFERRED EMBODIMENTS

The present invention is directed to an infrared emitter for emitting infrared light in a narrow band of wavelengths. The apparatus constructed according to the present invention also absorbs electromagnetic waves at the same peak wavelengths as it emits, and thereby the apparatus also can be used as an infrared detector or sensor.

The infrared emitter according to the present invention utilizes a photonic bandgap (PBG) structure (photonic crystal) to produce electromagnetic emissions with a narrow band of wavelengths. According to one preferred embodiment, the emitter 10 includes a semiconductor material layer 12, a dielectric material layer 14 overlaying the semiconductor material layer 12, and an electrically conductive material layer 16 having an inner side 15A overlaying the dielectric material layer 14.

Preferably, the semiconductor material layer 12 is preferably made from single-crystal silicon carbide (SiC), polycrystalline silicon carbide (poly-SiC), germanium, or the group III-V semiconductors, the group II-VI semiconductors, including alloys of indium, gallium, aluminum, arsenic, antimony, and phosphorous, and alloys of zinc, mercury, cadmium, tellurium, sulphur and selenium. SiC exhibits a mechanical hardness, chemical inertness, high thermal conductivity, and electrical stability at high temperatures, which make SiC a good candidate for the emitter devices according to the present invention, especially for the devices that operate in a high temperature environment. The semiconductor material layer 12 may be doped with N type or P type impurities. The dielectric material layer 14 is preferably made from silicon dioxide. According to one aspect of the present invention, the dielectric material layer is selected from the group consisting of silicon nitride, alumina, sapphire, aluminum nitride, and silicon oxinitride. The electrically conductive material layer can be made from a metallic material or a metallic-like material. The metallic material preferably is, but not limited to, selected from a group consisting of gold, aluminum, nickel, silver, titanium, and platinum, or an alloy of the above metals. In addition, the metallic-like material can be a highly doped semiconductor with effective metallic properties or a conductive ceramic preferably made from but not limited to a group consisting of titanium nitride, tantalum nitride, and indium tin oxide. The electrically conductive material layer hereinafter is referred to as metal or metallic material layer. The device 10 may have conductors connected to the semiconductor material layer 12 or the metallic material layer 16.

The semiconductor material layer 12 is capable of being coupled to an energy source for introducing energy to the semiconductor material layer 12. In one form, the semiconductor material layer 12 is coupled to an electrical current to effect resistive heating in the semiconductor material layer. Alternatively, the metallic material layer 16 is coupled to an electrical current, and the energy is transferred from the metallic material layer 16 to the semiconductor layer 12. Other energy sources, such as optical energy also can be used to heat the semiconductor material layer 12, for example, shining light onto the device 10. The metallic material layer 16 includes periodically distributed surface features on an outer side 15B thereof opposite the inner side 15A. The three material layers 12, 14, and 16 are adapted to transfer energy from the semiconductor material layer 12 to the outer side 15B of the material layer 16 and emit electromagnetic energy in a narrow band of wavelengths from the outer side 15B of the metallic material layer 16. The multi-layer structure emits electromagnetic waves with narrow peak wavelengths based on their resonances.

In one preferred form, the emitted electromagnetic energy has wavelengths centered about a characteristic wavelength (λ) and having a full width at half maximum (Δλ), where Δλ/λ is equal to or less than 0.5. The center wavelength (λ) is primarily defined by the spacing of the periodically distributed surface features and the full width at half maximum (Δλ) is primarily defined by the size of the periodically distributed surface features.

In use, the semiconductor material layer 12 is thermally stimulated, for example, by conducting electrical current to the semiconductor material layer 12 to effect resistive heating. Upon being heated, the semiconductor layer 12 emits photons. The dielectric material layer 14 couples the photons from the semiconductor material layer 12 to the inner and outer sides 15A and 15B of the metallic material layer 16. The photons excite plasmons at the metallic material layer 16. The surface plasmons at the inner and outer sides 15A and 15B of the metallic material layer 16 then decay into photons that are emitted from the outer surface 15B of the metallic material layer 16. According to one preferred embodiment, the narrow band of wavelengths emitted or absorbed by the device 10 is in infrared spectrum. According to anther form, the emitted electromagnetic energy is in visible spectrum or millimeter wave spectrum.

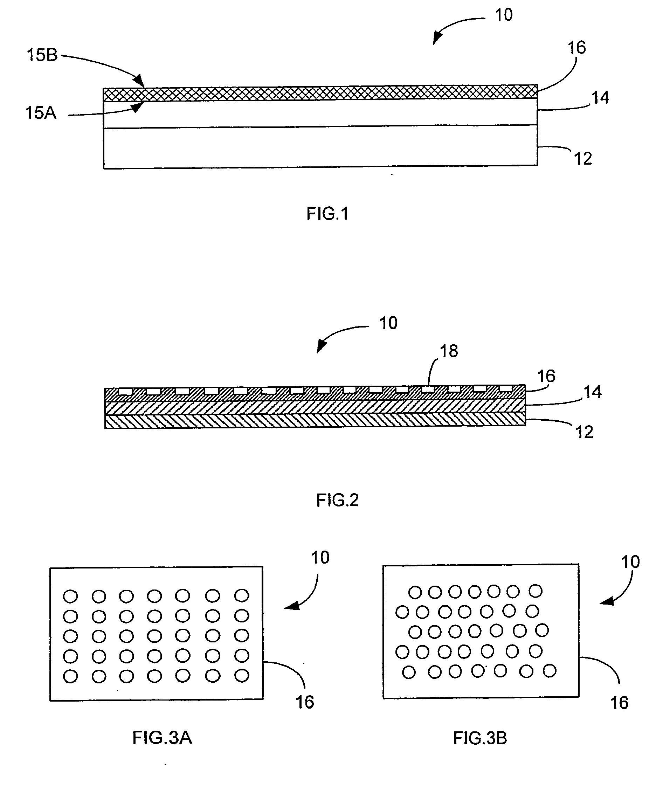

According to one preferred embodiment of the present invention, the periodically distributed surface features on the outer side 15B of the metallic material layer 16 are implemented by placing dielectric material in regions/holes in the metallic material layer 16. In another preferred form, the periodically distributed surface features are empty spaces, i.e. void regions or holes 18, defined in the metallic material layer 16, as shown in FIG.2. FIG.3A is a top view of the device 10, which shows a pattern of the holes 18 on the outer surface of the metallic material layer 16. As shown in FIG.3A, the holes 18 are distributed with a rectangular geometry (e.g., a rectangular pattern). The periodically distributed surface features can be distributed with other patterns, for example, square, hexagonal, or parallelogram (as shown in the top view in FIG.3B), or periodic tiling patterns. The parallelogram geometry preferably has a pair of about 60-degree interior angles (hexagonal geometry), but any other angle can be used. According one preferred embodiment, the holes 18 are at least partially filled with a non-linear optical material. According to another form, the holes are at least partially filled with a dielectric material.

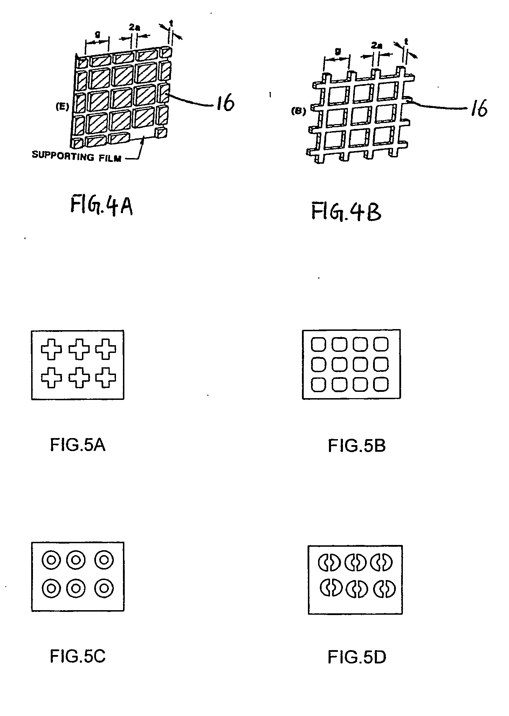

FIG.4A illustrates another embodiment of the surface features, in which a grid structure is removed from the metallic material layer 16, leaving discrete metal islands periodically distributed on the top surface of the device 10. Alternatively, square-shaped materials are removed from the metallic material layer 16 and leaves a continuous structure on the top surface, which is a metal grid, as shown in FIG.4B.

FIGS.3A and 3B show the holes 18 which are defined with a substantially circular shape. The holes 18 can be defined with other shapes, for example, a n-point star shape, such as a cross shape as shown in FIG.5A or an X shape, a square shape with round-shaped corners as shown in FIG.5B, or triangular, hexagonal, rectangular, donut shape as shown in FIG.5C, C-reverse-C shape as shown in FIG.5D, or other shapes.

The diameter of the substantially circular holes 18 and the inter-spacing between two holes can be varied in different embodiments. In one exemplary embodiment, the metal layer 16 is about 0.1 µm thick, and the diameter of the holes 18 is about 2 µm and the center to center spacing between two holes is about 4.2 µm. In other embodiments, in which the empty spaces are configured with rectangular or other shapes, the size and the spacing between two empty spaces can also be varied in different embodiments.

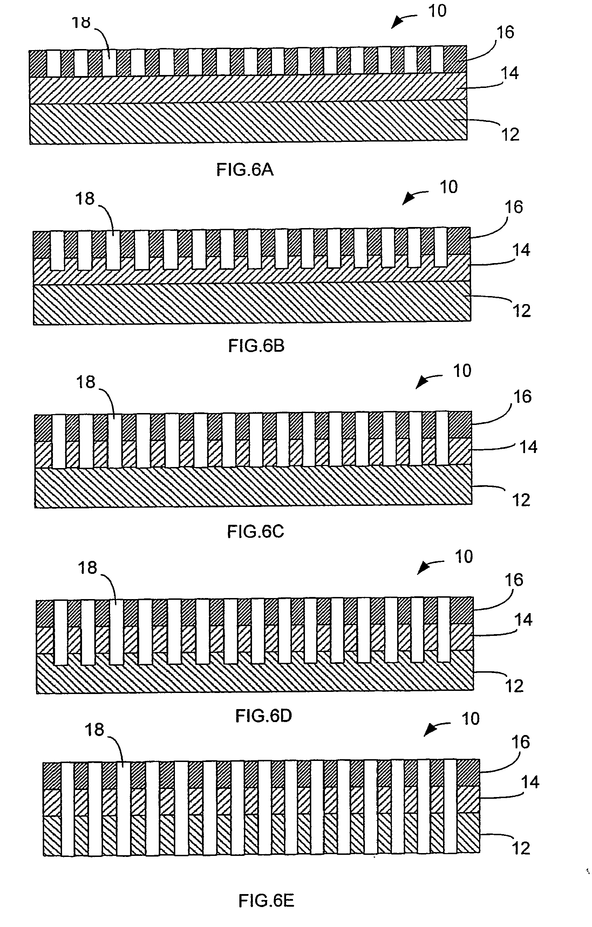

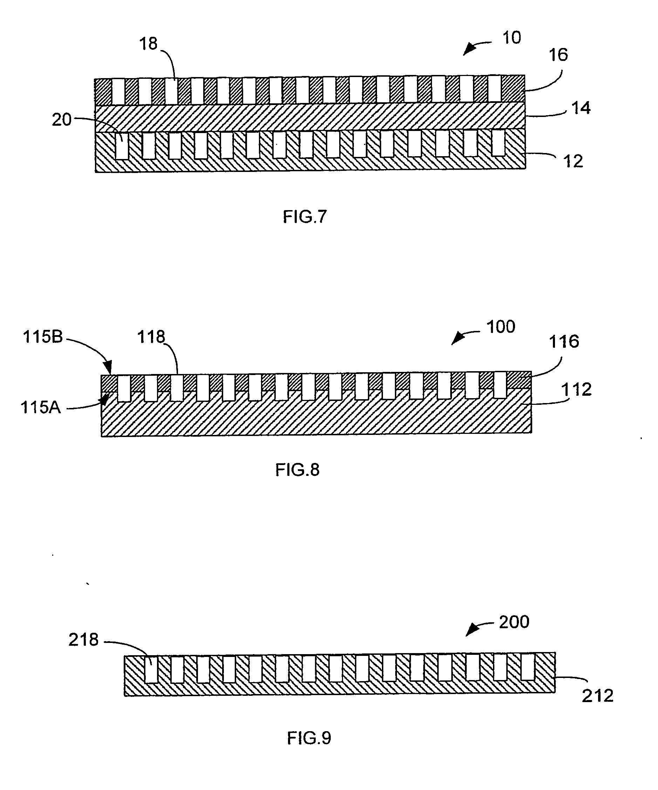

The holes 18 or the empty spaces can be defined with different depths in different embodiments. For example, the holes 18 may extend partially into the metal layer 16 as shown in FIG.2, or extend through the metal layer 16 as shown in FIG.6A, or extend through the metal layer 16 and into a portion of the dielectric layer 14 as shown in FIG.6B, or extend through the metal layer 16 and the dielectric layer 14 as shown in FIG.6C, or extend through the metal layer 16 and the dielectric layer 14, and into a portion of the semiconductor layer 12 as shown in FIG.6D, or extend through the metal layer 16, the dielectric layer 14, and the semiconductor layer 12 as shown in FIG.6E. FIG.7 illustrates a further embodiment, in which the holes 18 extend through the metal layer 16 and the semiconductor material layer 12 defines an array of periodically distributed holes 20 individually extending through at least a portion of the semiconductor material layer 12. Preferably the holes 18 of the metal layer 16 and the holes 20 of the semiconductor layer 12 are axially aligned.

It should be understood that any shape, size, depth, or spacing of the periodically distributed empty spaces can be used in the present invention. The emission or absorption peak wavelength and the width of the narrowband wavelengths around the peak wavelength can be adjusted by selecting the geometrical shape, size, depth, and spacing of the periodically distributed empty spaces (or holes). In particular, the peak wavelength is linearly proportional to the periodicity of the empty spaces (or holes) and the width of the narrowband is a function of the geometrical shape, size, and depth of the empty spaces (or holes). The peak wavelength and the width of the narrowband wavelengths around the peak wavelength also can be adjusted by selecting different materials, for example, different metals as the metal layer, or by adjusting the dopant concentration in the semiconductor layer. The center wavelength (λ) is defined by the spacing of the holes in the array and the full width at half maximum (Δλ) of the emitted electromagnetic energy is defined by the size (diameter and depth) of the holes in the array.

FIG.8 illustrates an exemplary device not according to the current invention, which only includes a semiconductor layer 112 and a metal layer 116 deposited on the semiconductor layer 112. The semiconductor layer 112 is capable of being coupled to an energy source. The metal layer 116 includes an inner surface 115A and an outer surface 115B. The inner surface 115A is the surface in contact with the semiconductor layer 112. The material of the semiconductor layer 112 and the metal layer 116 are the same as the semiconductor layer and the metal layer in device 10 as shown in FIGS. 1-7 and as described above. The metal layer 116 includes periodically distributed surface features 118 on the outer surface 115B. The configurations of the periodically distributed surface features 118 including the size, shape, depth, spacing, and distribution geometry can be the same as described in the embodiments shown in FIGS.1-7. For example, the periodically distributed surface features can be substantially circular holes defined through the metal layer 116 and into a portion of the semiconductor layer 112, as shown in FIG.8.

FIG.9 illustrates a further exemplary device not according to the present invention, in which the device 200 only includes one semiconductor layer 212. The semiconductor layer 212 may be made from single-crystal silicon carbide or poly-SiC. In an exemplary device not according to the current invention, the semiconductor layer 212 may be made from single crystal silicon or polysilicon. The semiconductor layer 212 is capable of being coupled to an energy source. The semiconductor layer 212 includes periodically distributed surface features 218 on an upper surface. The configurations of the periodically distributed surface features including the size, shape, depth, spacing, and distribution geometry can be the same as described in the embodiments shown in FIGS.1-7. For example, the periodically distributed surface features can be substantially circular holes defined at least partially through the semiconductor layer 212, as shown in FIG.9.

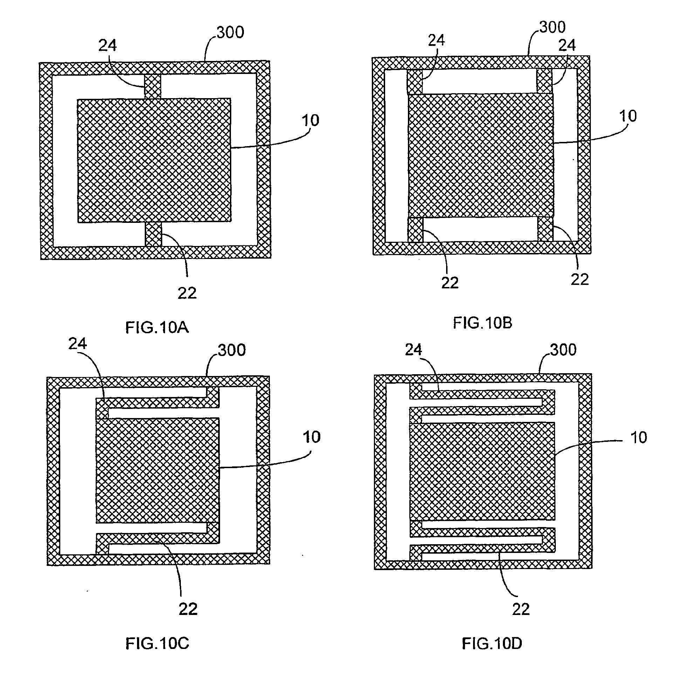

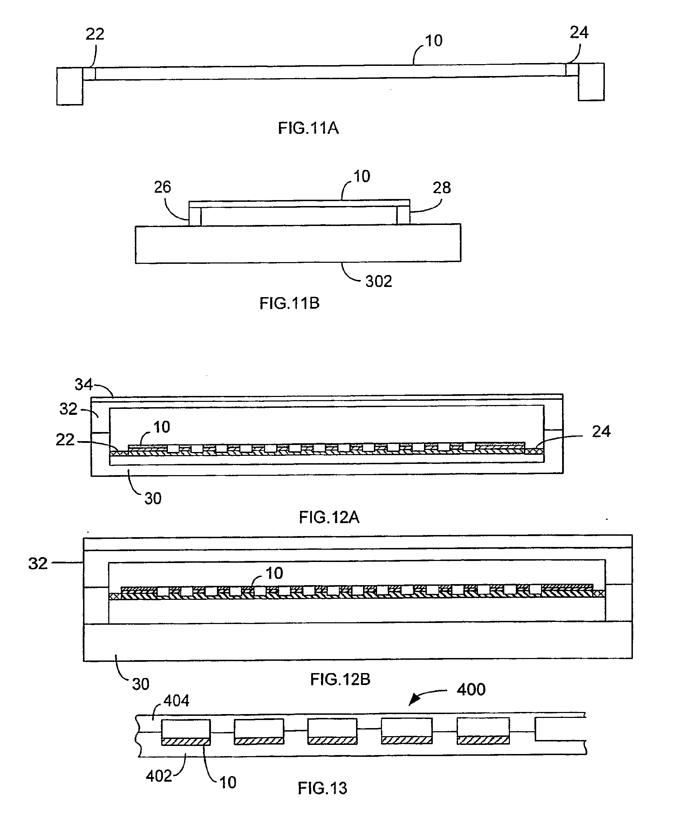

According to a further aspect of the present invention, the devices 10, 100, and 200 shown in FIGS.1-7 are preferably configured with a shape of a membrane. Preferably, but not necessarily, the membrane has an aspect ratio of the length or width to the thickness greater than 10. As shown in FIG.10A, the membrane 10, 100, or 200 (hereinafter only the device 10 is used as an exemplary embodiment) is suspended from a frame 300 by two uniaxial suspension arms 22 and 24. The resulting device is a MEMS device. The frame 300 and the suspension arms 22, 24 can be made from silicon, silicon carbide, or other materials. Preferably the membrane 10, suspension arms 22, 24, and the frame 300 are made from one semiconductor wafer and are constructed as an integral structure. The suspension arms 22 and 24 can be electrically conductive, thereby to conduct electrical energy to the semiconductor layer 12 of the device 10 to heat the semiconductor layer 12. Preferably the membrane 10 is thermally isolated from the frame to increase the accuracy of the device. The resulting MEMS device can be configured with other structures. For example, the suspension arms may employ other shapes, such as "H", "S", and "U" shape as shown in FIGS.10B, 10C, and 10D. For another example, the membrane 10 may be supported by supporting legs 26 and 28 on a substrate 302, as shown in FIG.11B. (Although only two legs are shown in the figure, the MEMS device may include more than two legs.) Contacts can be formed on the supporting legs 26 and 28 for conducting electrical energy to the semiconductor layer 12 of the device 10.

The fabrication of the devices may utilize MEMS manufacturing methods available in the art, which generally includes a number of photolithography and etching steps. Fabrication of the structure of the device 10 as shown in FIG.1, using a relative thick silicon layer as the semiconductor layer 12 may include growing oxide on a silicon substrate to form the silicon dioxide layer 14, depositing a metal layer 16 on the silicon dioxide layer 14, applying photoresist on the metal layer 16 and patterning the photoresist, and etching the structure to form the holes 18 on the device 10. As described above, the periodically distributed surface features may employ different configurations in different embodiments, and therefore, different masks may be used to achieve these different patterns of the periodically distributed surface features.

In another exemplary device the two-dimensional PBG patterns are processed in a passivated Si substrate. The PBG pattern was photolithographicly defined, followed by reactive ion etching (RIE) through the passivation layer and into the Si substrate. A second photolithographic step can be used to mask-off the etched holes, followed by e-beam evaporation of Ti, Pt, and Au. A liftoff process employing organic solvents is used to remove photoresist and excess metal.

Fabrication of the structures of the devices 100 and 200 as shown in FIGS.8 and 9 are similar to the fabrication process of the device 10 in FIG.1 as described above. For example, the device 100 shown in FIG.8 can be manufactured using the similar steps described above by skipping the growing oxide step.

In the embodiments in which silicon carbide is used as the semiconductor layer, an example process used to fabricate the devices is the Multi-User Silicon Carbide (MUSiC) process. The MUSIC process is available in the art. (see J.M. Melzak, A. Leppart, S. Rajgopal, and K.M. Moses, "MUSiC-An Enabling Microfabrication Process for MEMS," Commercialization of Micro Systems Conference (COMS 2002), Ypsilanti, MI, September 8-12, 2002.)

Fabrication of the structures on thin membranes as shown in FIGS.10A-10D, 11A, and 11B may utilize a sacrificial layer to support the membrane and after the structures of the membrane and the suspension arms are defined and the periodic features are formed on the top surface of the device, the sacrificial layer is removed using an etchant with high selectivity of the material of the sacrificial layer over the materials of the device.

In one preferred form, the MEMS device as depicted in FIGS.10A-10D, 11A and 11B is fabricated on an SOI silicon wafer, which includes a device layer, a dielectric layer, and a handle layer. The PGB etch is performed to pattern the membrane. Then the membrane is defined in the device layer using deep reactive ion etching (DRIE). The device is released by a backside-through etch, resulting in a suspended membrane structure spanning an open cavity, as shown in FIG.11A. A sacrificial material may be deposited to support the membrane. The sacrificial material is then removed from the device.

While the above embodiments exemplify methods for forming the devices of the present invention shown in FIGS.1-11B, any other manufacturing process suitable for forming the structures may be used. For example, the emitter may be formed on a separate membrane and then is bonded to a frame or substrate using wafer bonding techniques.

FIG.12A illustrates a further preferred embodiment, in which the emitter/detector device 10 is suspended by suspension arms 22 and 24 from a substrate or frame 30. The device 10 is covered by a transparent covering 32 which is preferably coated with a thin film 34 to decrease reflection of the transparent covering 32. In one preferred form, the transparent covering 32 is made from silicon. The thickness of the transparent covering 32 and the thin film 34 are arranged to achieve optimal transmission of a particular light spectrum that the emitter/detector is designed to emit/detect. The covering 32 is bonded to the substrate 30 and the emitter/detector device 10 is sealed in the interior region formed by the substrate 30 and the covering 32 from the outside environment. The interior region formed by the substrate 30 and the covering 32 is preferably vacuum, although the interior region can be maintained at atmosphere pressure or other pressures as desired. FIG.12B shows a three wafer structure, in which the device 10 is fabricated on one wafer as shown in FIG.11A, and is sandwiched between a substrate wafer 30 and a covering wafer 32.

The present disclosure has described the devices and methods of producing the devices in a single device level. Such devices are typically fabricated in large numbers on a wafer of a semiconductor material. The wafer scale assembly is then separated into individual devices. A person skilled in the art should appreciate that the wafer scale fabrication uses the same process as described above.

In wafer level manufacturing and packaging, an array of the emitter devices (which can be any embodiment as described above) are first fabricated on a wafer. Another wafer is etched to form an array of transparent coverings. The two wafers are then aligned and are bonded together. It is preferred that the two wafers are bonded together by silicon direct bonding. Silicon direct bonding, which is also called silicon fusion bonding, is a wafer-to-wafer bonding technology known in the art. Other alternatives wafer bonding techniques also can be used, which include but are not limited to anodic bonding, intermediate-layer bonding, glass frit bonding and the like. The two bonded wafers with the sealed emitter devices disposed inside are then separated into individual devices. In the example where the membrane is released using a backside through wafer etch, a third wafer is bonded to the backside of the device wafer sealing the backside of the device. Then the transparent covering wafer is bonded to the two wafer stack completing the sealed package.

A person skilled in the art should understand that the processes described above and in the figures only briefly illustrate the fabrication processes, and some detailed steps are not described in the description and in the figures. One skilled in the art should appreciate the whole fabrication process from the exemplary embodiments illustrated in the present disclosure. The specification describes the steps of the preferred processes in a sequence, but a person skilled in the art should understand that it may not be necessary to perform these steps in the sequence as described.

According to a further aspect of the present invention, an emitter device assembly may include an array of the emitter devices 10 (or other embodiments as described above). FIG. 13 schematically illustrates an emitter/detector assembly 400 (the figure shows part of the assembly), which includes an array of the devices 10. As seen in FIG. 13, the assembly 400 includes a substrate 402 and a covering 404. In a preferred form, the array of devices 10 are addressable individually or in groups. For example, each device 10 may include electrical conductors extending through the substrate 404 and are connected to an external power source and/or a controller, such that the each device 10 can be individually powered and/or controlled. The emitter/detector assembly 400 may be used in sensing or imaging systems.

### EXAMPLE I

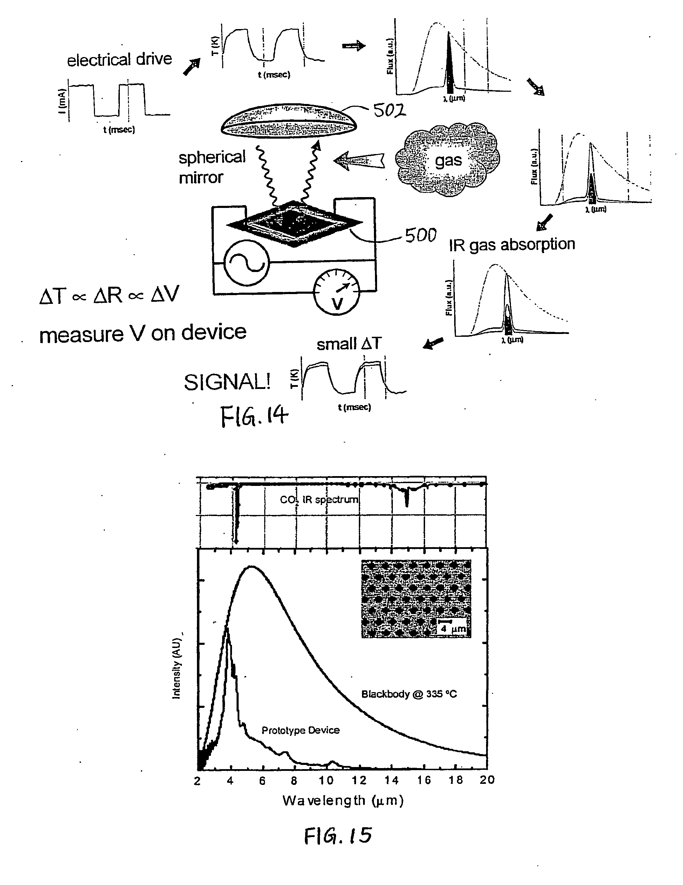

An infrared gas sensor is schematically shown in FIG.14. The infrared gas sensor utilizes a heated bolometer element, which employs a photonic bandgap structure, as both the source and the detector in an open path atmospheric gas measurement. The heated bolometer is a MEMS device as denoted by number 500, which is a thin silicon membrane with a gold coating. A repetitive pattern of holes are etched into the emitter surface. The repetitive pattern forms the 2-D photonic bandgap structure on the top surface of the MEMS device. The MEMS device is heated by passing an electrical current through the silicon layer, and the 2-D photonic bandgap coating emits a narrow line spectrum. The MEMS device also has particularly high absorption for the same wavelength it emits. The MEMS device 500 is placed opposite a mirror 502. In the absence of the monitored species (that absorb the electromagnetic energy at the emitted spectrum), the bolometer reaches radiative equilibrium with its surroundings. The presence of an absorbing gas in the optical path reduces light reflected back to the MEMS device causing the bolometer to cool off. This temperature change is detected by monitoring the resistance (or output voltage) of the MEMS device. The emission/absorption peak wavelength of the MEMS device is proportional to the pattern spacing. As shown in FIG. 15, the peak wavelength of the emission from the MEMS device is tuned to 4.26 µm, which is the infrared spectrum of carbon dioxide (CO₂). The width of the emission peak can be further reduced by adjusting the thickness of the metal coating, the depth of the etched holes into the silicon, and the diameter, spacing, and the distribution geometry of the etched holes.

### EXAMPLE II

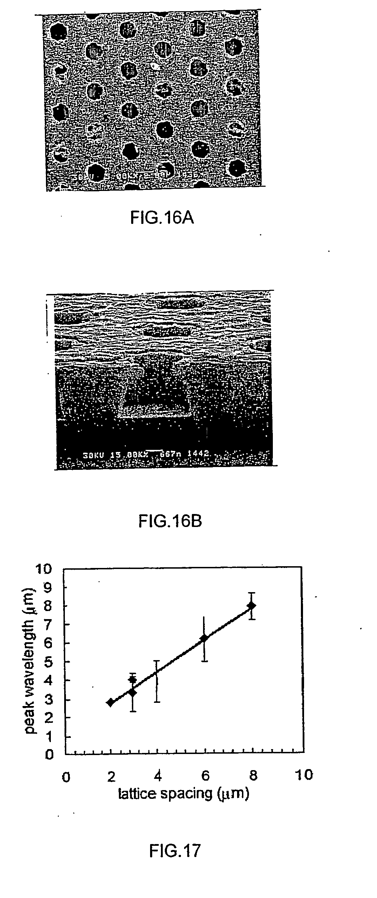

An emitter device including a SiC layer coated with platinum is fabricated. FIG.16A shows a top view of the device and FIG.16B shows a side cross-sectional view. As seen in FIG.16A, circular holes are etched into the SiC layer. The holes are distributed in a two-dimentional parallelogram lattice geometry. The diameter and the inter-spacing of the holes is about 2.5 µm. The depth of the holes is about 2 µm. The thickness of the platinum layer is less than 1 µm. As seen in the figures, the resulted holes may not be perfect circles. The metal recesses from the edge of some of the holes. The resulted device, upon heated by electrical current conducted to the SiC layer, emits/absorbs infrared light in a narrow wavelength band. Different devices with different inter-hole spacing are manufactured and tested. The peak wavelengths of the emissions are plotted as a function of the inter-hole spacing. As shown in FIG.17, the peak wavelength of the emissions is proportional to the inter-hole spacing.

## Claims

1. A device (10) for emitting and/or absorbing electromagnetic energy comprising:
a semiconductor material layer (12) capable of being coupled to an energy source for introducing energy to said semiconductor material layer (12), wherein said semiconductor material layer (12) is made from a semiconductor material other than silicon, wherein the semiconductor material layer (12) is adapted to emit photons in response to heating caused by the introduction of energy from the energy source; and
a metallic or metallic-like material layer (16) including periodically distributed surface features constituting a photonic bandgap structure, wherein the metallic or metallic-like material layer (16)is adapted to emit electromagnetic energy in response to the decay of plasmons on the metallic material layer (16) excited by the photons emitted by the semiconductor material layer;
a dielectric material layer (14) overlying the semiconductor material layer (12) and the metallic or metallic-like material layer (16) overlying the dielectric material layer (14), wherein the dielectric material is selected from the group consisting of silicon dioxide, silicon nitride, alumina, sapphire, aluminum nitride, and silicon oxynitride;
wherein said emitted electromagnetic energy centers about a characteristic wavelength (λ) and has a full width at half maximum (Δλ), wherein Δλ/λ is equal to or less than 0.5; and
wherein λ is defined by the spacing of the periodically distributed surface features or Δλ is defined by the geometrical size of the periodically distributed surface features.

2. The device (10) according to claim 1 wherein said metallic or metallic-like material layer (16) includes an inner side (15A) overlaying said dielectric material layer (14) and an outer side (15B) opposite said inner side (15A), and wherein said semiconductor material layer (12) is adapted to transfer energy to said outer side (15B) of said metallic or metallic-like material layer (16) via excitation of the said plasmons by the said photons.

3. The device (10) according to any of claims 1-2, wherein said semiconductor layer (12) comprises a material selected from the group consisting of single-crystal silicon carbide, polycrystalline silicon carbide, germanium, the group III-V semiconductors, and the group II-VI semiconductors; and
wherein said metallic or metallic-like material layer (16) comprises a material selected from the group consisting of gold, aluminum, nickel, silver, titanium, and platinum, a heavily doped semiconductor, a conductive ceramic, titanium nitride, tantalum nitride and indium tin oxide.

4. The device (10) according to any of claims 1-3, wherein the periodically distributed surface features comprise an array of holes (18) and the holes (18) individually extend through the metallic or metallic-like material layer (16), through the dielectric material layer (14), and through at least a portion of the semiconductor material layer (12); or,
wherein the holes (18) individually extend through the metallic or metallic-like material layer (16) and at least a portion of the dielectric material layer (14); or,
wherein the holes (18) individually extend through the metallic or metallic-like material layer (16), the dielectric material layer (14), and the semiconductor material layer (12); or
wherein the semiconductor material layer (12) defines an array of periodically distributed holes (20) individually extending through at least a portion of the semiconductor material layer (12).

5. The device (10) according to claim 4, wherein a non-linear optical material fills a portion of the holes (18, 20) in the array.

6. The device (10) according to claim 4, wherein a dielectric material fills a portion of the holes (18, 20) in the array.

7. The device (10) device according to any preceding claim, wherein the device (10) has a shape of a membrane having an aspect ratio of the length or width to the thickness greater than or equal to 10; and
wherein the device (10) includes a frame (30, 300) and suspension arms (22, 24), and wherein said membrane is suspended on said frame (30 300) by said suspension arms (22, 24) and said membrane is thermally isolated from said frame (30, 300).

8. The device (10) according to claim 7, wherein the device (10) includes a substrate (30, 302) and support legs (26, 28), and wherein said membrane is supported on the substrate (30, 302) by the support legs (26, 28) and wherein said membrane is thermally isolated from said substrate (30, 302).

9. The device (10) according to any preceding claim, wherein the device (10) includes electrical conductors connected to the semiconductor material layer (12) to couple electrical power to said semiconductor material layer (12) to effect resistive heating, thereby to thermally excite said semiconductor material layer (12) to emit photons.

10. The device (10) according to any preceding claim, wherein said metallic or metallic-like material layer (16) is in the form of an array of periodically distributed discrete elements.

11. The device (10) according to any preceding claim wherein said emitted electromagnetic energy is in the infrared spectrum, the visible spectrum, or the millimeter wave spectrum.

12. The device (10) according to any preceding claim wherein λ, or Δλ, is defined by the material of the periodically distributed surface features.

13. The device (10) according to any preceding claim, wherein the device (10) includes electrical conductors connected to the metallic or metallic-like material layer (16) to couple electrical power to effect resistive heating, thereby thermally exciting said semiconductor material layer (12) to emit photons.

14. The device (10) according to any of claims 1 to 8, wherein the energy source is an electrical current source or an optical energy source.

15. The device (10) according to claim 5, wherein λ or Δλ, is defined by the geometrical shape, size, depth, or spacing of the holes.

16. A method comprising:
providing a device (10) for emitting and/or absorbing electromagnetic energy according to any of the preceding claims; and
introducing energy to said semiconductor material layer (12) to cause the device (10) to emit radiation.

17. The method of claim 16, wherein the step of introducing energy to said semiconductor material layer (12) comprises:
coupling electrical power to said semiconductor material layer (12) to effect resistive heating, thereby thermally exciting said semiconductor material layer (12) to emit photons.

18. The method of claim 16, wherein the step of introducing energy to said semiconductor material layer (12) comprises:
coupling electrical power to said metallic or metallic-like material layer (16) to effect resistive heating, thereby thermally exciting said semiconductor material layer (12) to emit photons.

19. The method of claim 16 wherein λ or Δλ is adjusted by selecting the material of the periodically distributed surface features.

## Patentansprüche

1. Eine Vorrichtung (10) zum Emittieren und/oder Absorbieren elektromagnetischer Energie, die Folgendes beinhaltet:
eine Halbleitermaterialschicht (12), die mit einer Energiequelle gekoppelt werden kann, um Energie in die Halbleitermaterialschicht (12) einzuführen, wobei die Halbleitermaterialschicht (12) aus einem anderen Halbleitermaterial als Silizium hergestellt ist, wobei die Halbleitermaterialschicht (12) angepasst ist, um als Reaktion auf die durch die Einführung von Energie von der Energiequelle verursachte Erwärmung Photonen zu emittieren; und
eine metallische oder metallisch-ähnliche Materialschicht (16), einschließlich regelmäßig verteilte Oberflächenmerkmale, eine photonische Bandlücken-Struktur darstellend, wobei die metallische oder metallisch-ähnliche Materialschicht (16) angepasst ist, um als Reaktion auf den Zerfall von Plasmonen auf der metallischen Materialschicht (16), angeregt durch die von der Halbleitermaterialschicht emittierten Photonen, elektromagnetische Energie zu emittieren;
eine dielektrische Materialschicht (14) die Halbleitermaterialschicht (12) überlagernd und die metallische oder metallisch-ähnliche Materialschicht (16) die dielektrische Materialschicht (14) überlagernd, wobei das dielektrische Material aus der Gruppe ausgewählt ist, die aus Siliziumdioxid, Siliziumnitrid, Aluminiumoxid, Saphir, Aluminiumnitrid und Siliziumoxinitrid besteht;
wobei die emittierte elektromagnetische Energie um eine charakteristische Wellenlänge (λ) zentriert und eine volle Breite beim halben Maximum (Δλ) aufweist, wobei Δλ gleich oder weniger als 0,5 ist; und
wobei λ durch den Abstand der regelmäßig verteilten Oberflächenmerkmale definiert ist oder Δλ durch die geometrische Größe der regelmäßig verteilten Oberflächenmerkmale definiert ist.

2. Vorrichtung (10) gemäß Anspruch 1, wobei die metallische oder metallisch-ähnliche Materialschicht (16) eine Innenseite (15A) die dielektrische Materialschicht (14) überlagernd und eine Außenseite (158) gegenüber der Innenseite (15A) einschließt und wobei die Halbleitermaterialschicht (12) angepasst ist, um über Anregung der Plasmonen durch die Photonen Energie auf die Außenseite (158) der metallischen oder metallisch-ähnlichen Materialschicht (16) zu übertragen.

3. Vorrichtung (10) gemäß einem der Ansprüche 1-2, wobei die Halbleiterschicht (12) ein Material beinhaltet, das aus der Gruppe ausgewählt ist, die aus Einkristall-Siliziumkarbid, polykristallinem Siliziumkarbid, Germanium, der III-V-Halbleitergruppe und der II-VI-Halbleitergruppe besteht; und
wobei die metallische oder metallisch-ähnliche Materialschicht (16) ein Material beinhaltet, das aus der Gruppe ausgewählt ist, die aus Gold, Aluminium, Nickel, Silber, Titan und Platin, einem schwer dotierten Halbleiter, einer leitfähigen Keramik, Titannitrid, Tantalnitrid und Indiumzinnoxid besteht.

4. Vorrichtung (10) gemäß einem der Ansprüche 1-3, wobei die regelmäßig verteilten Oberflächenmerkmale eine Anordnung von Löchern (18) beinhalten und die Löcher (18) sich einzeln durch die metallische oder metallisch-ähnliche Materialschicht (16), durch die dielektrische Materialschicht (14) und durch mindestens einen Abschnitt der Halbleitermaterialschicht (12) erstrecken; oder
wobei die Löcher (18) sich einzeln durch die metallische oder metallisch-ähnliche Materialschicht (16) und durch mindestens einen Abschnitt der dielektrischen Materialschicht (14) erstrecken; oder
wobei die Löcher (18) sich einzeln durch die metallische oder metallisch-ähnliche Materialschicht (16), die dielektrische Materialschicht (14) und die Halbleitermaterialschicht (12) erstrecken; oder
wobei die Halbleitermaterialschicht (12) eine Anordnung von regelmäßig verteilten Löchern (20) definiert, die sich einzeln durch mindestens einen Abschnitt der Halbleitermaterialschicht (12) erstrecken.

5. Vorrichtung (10) gemäß Anspruch 4, wobei ein nicht-lineares optisches Material einen Abschnitt der Löcher (18, 20) in der Anordnung füllt.

6. Vorrichtung (10) gemäß Anspruch 4, wobei ein dielektrisches Material einen Abschnitt der Löcher (18, 20) in der Anordnung füllt.

7. Vorrichtung (10) gemäß einem der vorhergehenden Ansprüche, wobei die Vorrichtung (10) eine Gestalt einer Membran aufweist mit einem Aspektverhältnis der Länge oder Breite zur Dicke größer als oder gleich 10; und
wobei die Vorrichtung (10) einen Rahmen (30, 300) und Aufhängungsarme (22, 24) einschließt und wobei die Membran am Rahmen (30 300) durch die Aufhängungsarme (22, 24) aufgehängt ist und die Membran vom Rahmen (30, 300) thermisch isoliert ist.

8. Vorrichtung (10) gemäß Anspruch 7, wobei die Vorrichtung (10) ein Substrat (30, 302) und Stützbeine (26, 28) einschließt und wobei die Membran auf dem Substrat (30, 302) durch die Stützbeine (26, 28) gestützt ist und die Membran vom Substrat (30, 302) thermisch isoliert ist.

9. Vorrichtung (10) gemäß einem der vorhergehenden Ansprüche, wobei die Vorrichtung (10) elektrische Leiter einschließt, die an der Halbleitermaterialschicht (12) angeschlossen sind, um elektrische Leistung mit der Halbleitermaterialschicht (12) zu koppeln, um Widerstandsheizung zu bewirken, um damit die Halbleitermaterialschicht (12) thermisch anzuregen, um Photonen zu emittieren.

10. Vorrichtung (10) gemäß einem der vorhergehenden Ansprüche, wobei die metallische oder metallisch-ähnliche Materialschicht (16) in der Form einer Anordnung von regelmäßig verteilten diskreten Elementen vorliegt.

11. Vorrichtung (10) gemäß einem der vorhergehenden Ansprüche, wobei die emittierte elektromagnetische Energie im Infrarotspektrum, im sichtbaren Spektrum oder im Millimeterwellenspektrum liegt.

12. Vorrichtung (10) gemäß einem der vorhergehenden Ansprüche, wobei λ, oder Δλ, durch das Material der regelmäßig verteilten Oberflächenmerkmale definiert ist.

13. Vorrichtung (10) gemäß einem der vorhergehenden Ansprüche, wobei die Vorrichtung (10) elektrische Leiter einschließt, die an der metallischen oder metallisch-ähnlichen Materialschicht (16) angeschlossen sind, um elektrische Leistung zu koppeln, um Widerstandsheizung zu bewirken, damit die Halbleitermaterialschicht (12) thermisch angeregt wird, um Photonen zu emittieren.

14. Vorrichtung (10) gemäß einem der Ansprüche 1 bis 8, wobei die Energiequelle eine elektrische Stromquelle oder eine optische Energiequelle ist.

15. Vorrichtung (10) gemäß Anspruch 5, wobei λ oder Δλ durch die geometrische Gestalt, Größe, Tiefe oder den Abstand der Löcher definiert ist.

16. Ein Verfahren, das Folgendes beinhaltet:
Bereitstellen einer Vorrichtung (10) zum Emittieren und/oder Absorbieren elektromagnetischer Energie gemäß einem der vorhergehenden Ansprüche; und
Einführen von Energie in die Halbleitermaterialschicht (12), um zu bewirken, dass die Vorrichtung (10) Strahlung emittiert.

17. Verfahren gemäß Anspruch 16, wobei der Schritt des Einführens von Energie in die Halbleitermaterialschicht (12) Folgendes beinhaltet:
Koppeln von elektrischer Leistung mit der Halbleitermaterialschicht (12), um Widerstandsheizung zu bewirken, damit die Halbleitermaterialschicht (12) thermisch angeregt wird, um Photonen zu emittieren.

18. Verfahren gemäß Anspruch 16, wobei der Schritt des Einführens von Energie in die Halbleitermaterialschicht (12) Folgendes beinhaltet:
Koppeln von elektrischer Leistung mit der metallischen oder metallisch-ähnlichen Materialschicht (16), um Widerstandsheizung zu bewirken, damit die Halbleitermaterialschicht (12) thermisch angeregt wird, um Photonen zu emittieren.

19. Verfahren gemäß Anspruch 16, wobei λ oder Δλ durch Auswählen des Materials der regelmäßig verteilten Oberflächenmerkmale geändert wird.

## Revendications

1. Dispositif (10) pour l'émission et/ou l'absorption de l'énergie électromagnétique comprenant :
une couche de matériau semi-conducteur (12) pouvant être couplée à une source d'énergie pour introduire de l'énergie dans ladite couche de matériau semi-conducteur (12), dans lequel ladite couche de matériau semi-conducteur (12) est fabriquée dans un matériau semi-conducteur autre que le silicium, dans lequel la couche de matériau semi-conducteur (12) est adaptée pour émettre des photons en réponse à un échauffement causé par l'introduction d'énergie depuis la source d'énergie ; et
une couche de matériau métallique ou semblable au métal (16) incluant des caractéristiques de surface distribuées de manière périodique constituant une structure à bande interdite photonique, dans lequel la couche de matériau métallique ou semblable au métal (16) est adaptée pour émettre de l'énergie électromagnétique en réponse à la désintégration des plasmons sur la couche de matériau métallique (16) excités par les photons émis par la couche de matériau semi-conducteur ;
une couche de matériau diélectrique (14) recouvrant la couche de matériau semi-conducteur (12) et la couche de matériau métallique ou semblable au métal (16) recouvrant la couche de matériau diélectrique (14), dans lequel le matériau diélectrique est choisi dans le groupe comprenant le dioxyde de silicium, le nitrure de silicium, l'alumine, le saphir, le nitrure d'aluminium et l'oxynitrure de silicium ;
dans lequel ladite énergie électromagnétique émise est concentrée autour d'une longueur d'onde (λ) caractéristique et a une largeur à mi-hauteur (Δλ), dans lequel Δλ/λ est égal ou inférieur à 0,5 ; et
dans lequel λ est défini par l'espacement des caractéristiques de surface distribuées de manière périodique ou Δλ est défini par la taille géométrique des caractéristiques de surface distribuées de manière périodique.

2. Dispositif (10) selon la revendication 1 dans lequel ladite couche de matériau métallique ou semblable au métal (16) comprend une face intérieure (15A) recouvrant ladite couche de matériau diélectrique (14) et une face extérieure (15B) opposée à ladite face intérieure (15A), et dans lequel ladite couche de matériau semi-conducteur (12) est adaptée pour transférer de l'énergie jusqu'à ladite face extérieure (15B) de ladite couche métallique ou semblable au métal (16) au moyen de l'excitation desdits plasmons par lesdits photons.

3. Dispositif (10) selon l'une quelconque des revendications 1 à 2, dans lequel ladite couche semi-conductrice (12) comprend un matériau choisi dans le groupe comprenant le carbure de silicium monocristallin, le carbure de silicium polycristallin, le germanium, les semi-conducteurs du groupe III-V et les semi-conducteurs du groupe II-VI ; et
dans lequel ladite couche de matériau métallique ou semblable au métal (16) comprend un matériau choisi dans le groupe comprenant l'or, l'aluminium, le nickel, l'argent, le titane et le platine, un semi-conducteur fortement dopé, une céramique conductrice, le nitrure de titane, le nitrure de tantale et l'oxyde d'étain et d'indium.

4. Dispositif (10) selon l'une quelconque des revendications 1 à 3, dans lequel les caractéristiques de surface distribuées de manière périodique comprennent un réseau de trous (18) et les trous (18) s'étendent individuellement à travers la couche de matériau métallique ou semblable au métal (16), à travers la couche de matériau diélectrique (14) et à travers au moins une partie de la couche de matériau semi-conducteur (12) ; ou,
dans lequel les trous (18) s'étendent individuellement à travers la couche de matériau métallique ou semblable au métal (16) et au moins une partie de la couche de matériau diélectrique (14) ; ou,
dans lequel les trous (18) s'étendent individuellement à travers la couche de matériau métallique ou semblable au métal (16), la couche de matériau diélectrique (14) et la couche de matériau semi-conducteur (12) ; ou
dans lequel la couche de matériau semi-conducteur (12) définit un réseau de trous distribués de manière périodique (20) s'étendant individuellement à travers au moins une partie de la couche de matériau semi-conducteur (12).

5. Dispositif (10) selon la revendication 4, dans lequel un matériau optique non linéaire remplit une partie des trous (18, 20) dans le réseau.

6. Dispositif (10) selon la revendication 4, dans lequel un matériau diélectrique remplit une partie des trous (18, 20) dans le réseau.

7. Dispositif (10) selon l'une quelconque des revendications précédentes, dans lequel le dispositif (10) a la forme d'une membrane ayant un rapport de forme de la longueur ou largeur et de l'épaisseur supérieur ou égal à 10 ; et
dans lequel le dispositif (10) comprend un cadre (30, 300) et des bras de suspension (22, 24), et dans lequel ladite membrane est suspendue audit cadre (30, 300) par lesdits bras de suspension (22, 24) et ladite membrane est isolée thermiquement dudit cadre (30, 300).

8. Dispositif (10) selon la revendication 7, dans lequel le dispositif (10) comprend un substrat (30, 302) et des supports de jambe (26, 28) et dans lequel ladite membrane est soutenue sur le substrat (30, 302) par les supports de jambe (26, 28) et dans lequel ladite membrane est thermiquement isolée dudit substrat (30, 302).

9. Dispositif (10) selon l'une quelconque des revendications précédentes, dans lequel le dispositif (10) comprend des conducteurs électriques connectés à la couche de matériau semi-conducteur (12) pour coupler du courant électrique à ladite couche de matériau semi-conducteur (12) pour effectuer un chauffage par résistance, pour ainsi exciter thermiquement ladite couche de matériau semi-conducteur (12) pour émettre des photons.

10. Dispositif (10) selon l'une quelconque des revendications précédentes, dans lequel ladite couche de matériau métallique ou semblable au métal (16) est sous la forme d'un réseau d'éléments discrets distribués de manière périodique.

11. Dispositif (10) selon l'une quelconque des revendications précédentes, dans lequel ladite énergie électromagnétique émise se trouve dans le spectre infrarouge, le spectre visible ou le spectre des ondes millimétriques.

12. Dispositif (10) selon l'une quelconque des revendications précédentes, dans lequel λ ou Δλ est défini par le matériau des caractéristiques de surface distribuées de manière périodique.

13. Dispositif (10) selon l'une quelconque des revendications précédentes, dans lequel le dispositif (10) comprend des conducteurs électriques connectés à la couche de matériau métallique ou semblable au métal (16) pour coupler du courant électrique pour effectuer un chauffage par résistance, excitant ainsi thermiquement ladite couche de matériau semi-conducteur (12) pour émettre des photons.

14. Dispositif (10) selon l'une quelconque des revendications 1 à 8, dans lequel ladite source d'énergie est une source de courant électrique ou une source d'énergie optique.

15. Dispositif (10) selon la revendication 5, dans lequel λ ou Δλ est défini par la forme géométrique, la taille, la profondeur ou l'espacement des trous.

16. Procédé comprenant :
la fourniture d'un dispositif (10) pour émettre et/ou absorber l'énergie électromagnétique selon l'une quelconque des revendications précédentes ; et
introduire de l'énergie dans la couche de matériau semi-conducteur (12) pour amener le dispositif (10) à émettre un rayonnement.

17. Procédé selon la revendication 16, dans lequel l'étape consistant à introduire de l'énergie dans la couche de matériau semi-conducteur (12) comprend :
le couplage de courant électrique à ladite couche de matériau semi-conducteur (12) pour effectuer un chauffage par résistance, excitant ainsi thermiquement ladite couche de matériau semi-conducteur (12) pour émettre des photons.

18. Procédé selon la revendication 16, dans lequel l'étape consistant à introduire de l'énergie dans la couche de matériau semi-conducteur (12) comprend :
le couplage de courant électrique à ladite couche de matériau métallique ou semblable à du métal (16) pour effectuer un chauffage par résistance, excitant ainsi thermiquement ladite couche de matériau semi-conducteur (12) pour émettre des photons.

19. Procédé selon la revendication 6, dans lequel λ ou Δλ est ajusté en choisissant le matériau des caractéristiques de surface distribuées de manière périodique.
